# EUROPÄISCHE PATENTSCHRIFT

(11) **EP 2 407 795 B1**
(45) Veröffentlichungstag und Bekanntmachung des Hinweises auf die Patenterteilung: **12.10.2016**
(21) Anmeldenummer: 11005511.8
(22) Anmeldetag: 06.07.2011
(51) Int. Cl.: G01R 31/12, G01R 31/14

(54) **Messeinrichtung zur Messung von Teilentladungen**
Measurement device for measuring partial discharge
Dispositif de mesure pour mesurer une décharge partielle

(30) Priorität: 12.07.2010 AT 11742010
(43) Veröffentlichungstag der Anmeldung: 18.01.2012
(73) Patentinhaber: Baur Prüf- und Messtechnik GmbH, 6832 Sulz (AT)
(72) Erfinder: Baur, Martin, 6832 Röthis (AT)
(74) Vertreter: Hofmann, Ralf U.

(56) Entgegenhaltungen:
- WO-A1-96/13730
- CLEARY G P ET AL: "UHF and current pulse measurements of partial discharge activity in mineral oil", IEE PROCEEDINGS: SCIENCE, MEASUREMENT AND TECHNOLOGY, IEE, STEVENAGE, HERTS, GB, Bd. 153, Nr. 2, 9. März 2006 (2006-03-09), Seiten 47-54, XP006026074, ISSN: 1350-2344, DOI: 10.1049/IP-SMT:20050103
- MASSIMO POMPILI ED - LESAINT O: "Partial discharge measurements in dielectric liquids", DIELECTRIC LIQUIDS, 2008. ICDL 2008. IEEE INTERNATIONAL CONFERENCE ON, IEEE, PISCATAWAY, NJ, USA, 30. Juni 2008 (2008-06-30), Seiten 1-7, XP031319456, ISBN: 978-1-4244-1585-4
- STONE G C: "Partial discharge. VII. Practical techniques for measuring PD in operating equipment", IEEE ELECTRICAL INSULATION MAGAZINE, IEEE SERVICE CENTER, NEW YORK, NY, US, Bd. 7, Nr. 4, 1. Juli 1991 (1991-07-01), Seiten 9-19, XP011418586, ISSN: 0883-7554, DOI: 10.1109/57.87656

## Beschreibung

Die Erfindung bezieht sich auf eine Messeinrichtung zur Messung von Teilentladungen in Isolierflüssigkeiten, welche erste und zweite Elektroden, die in einem Behälter zur Aufnahme der zu messenden Isolierflüssigkeit angeordnet sind und zwischen denen eine Spannung anlegbar ist, mindestens einen Breitband-Sensor, von dem Messwerte für die Teilentladungen ausgebbar sind, und einen Faradayschen Käfig umfasst, innerhalb von dem der Behälter mit den Elektroden angeordnet ist.

Zur Messung der Teilentladungseinsatzspannung (PDIV-Partial Discharge Inception Voltage) wurde im Entwurf IEC TR 61294:2006 einer Prüfnorm ein Schmalband-Sensor mit einer Bandbreite von 300 kHz vorgeschlagen. Die Messung erfolgt über eine Messimpedanz, die von einem Auskoppelvierpol gebildet wird und die zusammen mit einem Auskoppelkondensator einer Prüfzelle, welche die zu messende Isolierflüssigkeit aufnimmt, parallel geschaltet ist. Eine Erweiterung hiervon wird von Pompili, Massimo, ICDL 2008, 16th IEEE International Conference on Dielectric Liquids, Tropper Memorial Lecture, "Partial Discharge Measurements in Dielectric Liquids" bzw. in IEEE Transactions on Dielectrics and Electrical Insulation Vol.16, No. 6; December 2009, 1511-1518, "Comparative PD Pulse Burst Characteristics of Transformer Type Natural and Synthetic Ester Fluids and Minerals Oils", M. Pompili et al. vorgeschlagen. Hier wird die integrative Messung mittels des Schmalband-Sensors erweitert durch eine Messung mittels eines Breitband-Sensors, der eine Bandbreite von 500 MHz aufweist und den Spannungsabfall an einem Messwiderstand erfasst. Der Messwiderstand ist in die Leitung geschaltet, die zwischen einer der beiden Elektroden der Prüfzelle, welche in der zu messenden Isolierflüssigkeit angeordnet sind, und dem Erdpotential verläuft. An die andere der beiden Elektroden wird eine Hochspannung in Form einer Wechselspannung angelegt. Vom Breitband-Sensor werden die einzelnen Spannungspulse erfasst, welche von einer jeweiligen Teilentladung in der Isolierflüssigkeit herrühren.

Eine Messung von Teilentladungen an elektrischen Komponenten ist weiters in der Norm CEI/IEC 60270:2000 normiert. In dieser ist die Messung mittels eines Schmalband-Sensors beschrieben.

Weitere Normen, die sich mit der Messung von Teilentladungen befassen sind die ASTM D 3382-95 (Reapproved 2001) und die ASTM D 1868-93 (Reapproved 1998). Es ist bekannt Messeinrichtungen zur Messung von Teilentladungen in Faradayschen Käfigen anzuordnen, um eine Abschirmung gegen Störeinflüsse zu erreichen. Herkömmlicherweise weisen diese auf Grund der erforderlichen Isolierstrecke in Luft und der eingesetzten Hochspannung, die beispielsweise im Bereich von 1 kV bis zu mehreren 100 kV liegen kann, große Abmessungen auf, wobei der Abstand zwischen dem Faradayschen Käfig und hochspannungsführenden Teilen der Messeinrichtung im Meter-Bereich liegt.

Ein weiteres Beispiel für eine Messeinrichtung zur Messung von Teilentladungen mit Breitbandsensoren und Faradayschem Käfig wird von Cleary et al. in IEE Proc.-Sci Meas. Technol., Vol.1 53, No.2, March 2006, "UHF and current pulse measurements of partial discharge activity in mineral oil" beschrieben.

Aufgabe der Erfindung ist es eine verbesserte Messeinrichtung der eingangs genannten Art bereitzustellen. Erfindungsgemäß gelingt dies durch eine Messeinrichtung mit den Merkmalen des Anspruchs 1.

Bei einer Messeinrichtung gemäß der Erfindung zur Messung von Teilentladungen sind erste und zweite Spannungsquellen vorhanden, mit denen an der ersten und an der zweiten Elektrode jeweils eine Wechselspannung gegenüber Erdpotential anlegbar ist. Die an den beiden Elektroden anliegenden Wechselspannungen weisen zumindest im Wesentlichen gleiche Amplituden (= Scheitelwerte) auf, d.h. ihre Amplituden unterscheiden sich um weniger als 5%. Die beiden Spannungen sind gegenphasig, also um 180° gegeneinander phasenverschoben.

Auf diese Weise können, wenn eine Messung von Teilentladungen in einer Isolierflüssigkeit bei einer vorgegebenen Potentialdifferenz zwischen der ersten und der zweiten Elektrode durchzuführen ist, beide Elektroden gegenüber Erde nur die Hälfte dieser gewünschten, zwischen den beiden Elektroden anliegenden Potentialdifferenz aufweisen. Die Anordnung kann damit kompakt ausgebildet werden, insbesondere können die Abmessungen des Faradayschen Käfigs, innerhalb von dem der Aufnahmebehälter für die Isolierflüssigkeit angeordnet ist, verringert werden.

Die Erfassung von Messwerten für die Teilentladungen erfolgt auf der Basis von Stromimpulsen, die durch die Teilentladungen in einer jeweiligen elektrischen Leitung hervorgerufen werden, die zwischen der jeweiligen Spannungsquelle und der jeweiligen Elektrode verläuft (gegebenenfalls unter Zwischenschaltung von elektrischen Bauelementen). Diese Stromimpulse können vom (jeweiligen) Breitband-Sensor vorteilhafterweise berührungslos erfasst werden, beispielsweise mittels einer Rogowski-Spule oder mittels einem Hall-Sensor oder mittels einer Antenne, die ein von den Stromimpulsen hervorgerufenes, von der Leitung abgestrahltes elektromagnetisches Feld empfängt. Eine andere Möglichkeit sieht vor, dass in die (jeweilige) elektrischen Leitung eine Messimpedanz geschaltet wird und vom (jeweiligen) Breitband-Sensor der Spannungsabfall an der Messimpedanz erfasst wird. Insbesondere wird diese (bzw. die jeweilige) Messimpedanz von einem ohmschen Widerstand gebildet.

In die jeweilige, zwischen der jeweiligen Spannungsquelle und der jeweiligen Elektrode verlaufenden Leitung ist günstigerweise, gegebenenfalls seriell zur Messimpedanz, ein Schutzwiderstand geschaltet. Im Falle der Anordnung einer Messimpedanz in dieser Leitung, liegt der Schutzwiderstand vorzugsweise zwischen der Messimpedanz und der Spannungsquelle, wobei sein ohmscher Widerstand wesentlich höher als der der Messimpedanz ist, vorzugsweise mehr als 10 mal, besonders bevorzugt mehr als 100 mal höher. Der Schutzwiderstand schützt die Messeinrichtung, falls es im Zuge der Messung zu einer voll-ständigen Entladung kommen sollte, also die Durchschlagsspannung der gemessenen Isolierflüssigkeit überschritten werden sollte.

In einer bevorzugten Ausführungsform der Erfindung sind erste und zweite Breitband-Sensoren vorhanden. Der erste Breitband-Sensor erfasst Stromimpulse in der zwischen der ersten Spannungsquelle und der ersten Elektrode verlaufenden ersten elektrischen Leitung, beispielsweise durch Erfassung eines von solchen Stromimpulsen hervorgerufenen elektromagnetischen Feldes oder durch Erfassung eines Spannungsabfalls an einer ersten, in die erste Leitung geschalteten Messimpedanz. Der zweite Breitband-Sensor erfasst Stromimpulse in der zwischen der zweiten Spannungsquelle und der zweiten Elektrode verlaufenden zweiten elektrischen Leitung, beispielsweise durch Erfassung eines von solchen Stromimpulsen hervorgerufenen elektromagnetischen Feldes oder durch Erfassung eines Spannungsabfalls an einer zweiten, in der zweiten elektrischen Leitung geschalteten Messimpedanz. Dadurch werden die Möglichkeiten zur Messung erweitert. Je nach Art der Defekte in der Isolierung der Isolierflüssigkeit entstehen unterschiedliche Muster von Teilentladungen. Diese sind in ihrer Phasenlage, Amplitude und Häufung (Anzahl pro Periode) sehr typisch. Damit können Fehlerursachen erkannt werden. Durch die bevorzugte symmetrische Anordnung können diese Muster an beiden Elektroden gleichzeitig und mit gegenläufiger Phasenlage von den beiden Breitband-Sensoren gemessen werden. Die Möglichkeiten in der Mustererkennung der Teilentladungen können dadurch erweitert werden. Durch Bildung von Differenzsignalen können Störsignale unterdrückt werden. Die Messergebnisse können in ihrer wiederholten Genauigkeit um ein Vielfaches verbessert werden.

Die erste und zweite Spannungsquellen werden vorteilhafterweise von einem Transformator gebildet. Dieser weist eine Primärwicklung und erste und zweite Sekundärwicklungen auf, die durch einen Mittelabgriff getrennt sind. Der Mittelabgriff wird auf Erdpotential gelegt. Die anderen beiden Enden der ersten und zweiten Sekundärwicklung werden mit der ersten und zweiten Elektrode verbunden (gegebenenfalls über die in die jeweilige Leitung geschalteten Bauteile, vorzugsweise also jeweils zumindest über einen Schutzwiderstand und gegebenenfalls die Messimpedanz). Die vom Transformator abgegebene Spannung kann durch die Änderung der an der Primärwicklung anliegenden Spannung geändert werden, insbesondere programmgesteuert.

Die ersten und zweiten Spannungsquellen liefern Hochspannung (also Spannungen oberhalb von 1 kV). An die Elektroden können vorzugsweise Spannungen von jeweils zumindest bis zu 50 kV angelegt werden, sodass zwischen der ersten und der zweiten Elektrode eine Messspannung von zumindest bis zu 100 kV angelegt werden kann. Die Amplitudenverläufe der an die beiden Elektroden angelegten Spannungen sind gleich, insbesondere sinusförmig.

Um kleine Abmessungen zu erreichen, ist der Transformator vorteilhafterweise in einem Bad mit einer isolierenden Flüssigkeit angeordnet.

Die Bandbreiten der Breitband-Sensoren liegen vorzugsweise im Bereich von 100 MHz bis 1000 MHz.

Da ein jeweiliger Breitband-Sensor auf Hochspannungspotential (d.h. > = 1 kV) liegt, werden die vom mindestens einen Breitband-Sensor erfassten Messwerte günstigerweise über den freien Raum (drahtlos) oder über ein Glasfaserkabel an eine Empfangseinheit übertragen, welche nicht auf Hochspannungspotential liegt, insbesondere auf einem Kleinspannungspotential (d.h. < = 50 Volt) liegt. Zur Energieversorgung eines jeweiligen Breitband-Sensors ist günstigerweise eine jeweilige Batterie oder ein jeweiliger Akkumulator (wiederaufladbare Batterie oder Speicherkondensator) vorhanden. Im Falle des Einsatzes eines Akkumulators kann eine Wiederaufladung in Pausenzeiten der Messung erfolgen, wobei die beiden Elektroden kurzgeschlossen sind und eine Ladespannung einer geeigneten Höhe angeschlossen ist. Als Spannungsquelle kann vorteilhafterweise der auch die zur Messung benötigte Hochspannung liefernde Transformator eingesetzt werden.

Vorzugsweise ist weiters mindestens ein Schmalband-Sensor vorhanden, der Teilentladungen durch Ankopplung über mindestens einen Koppelkondensator erfasst. Ein jeweiliger Koppelkondensator ist einerseits mit der die jeweilige Spannungsquelle mit der jeweiligen Elektrode verbindenden Leitung verbunden, und zwar durch eine Verbindungsleitung oder durch eine einstückige Ausbildung der einen Elektrode des Koppelkondensators mit einem Abschnitt dieser Leitung. Andererseits ist der jeweilige Koppelkondensator über eine Koppelimpedanz mit Erdpotential verbunden. Die an der Koppelimpedanz anliegende (bzw. von dieser ausgegebene) Spannung ist dem Schmalband-Sensor zugeführt. Bei der Koppelimpedanz handelt es sich in herkömmlicher Weise um einen Vierpol.

Vorzugsweise sind erste und zweite Koppelkondensatoren vorgesehen, die jeweils einerseits mit der jeweiligen elektrischen Leitung, über die die Spannungsversorgung der jeweiligen Elektrode erfolgt, und andererseits über eine jeweilige Koppelimpedanz mit Erdpotential verbunden sind. Vom Schmalband-Sensor kann damit eine Differenzmessung der an der jeweiligen Koppelimpedanz anliegenden Spannung (bzw. von dieser ausgegebenen Spannung) durchgeführt werden. Alternativ wäre es auch denkbar und möglich, jeder Koppelimpedanz einen eigenen Schmalband-Sensor zuzuordnen, der die an dieser Koppelimpedanz anliegende Spannung erfasst. Für die von diesen Sensoren ausgegebenen Messwerte könnte, falls gewünscht, ein Differenzsignal gebildet werden.

Mittels des mindestens einen Schmalband-Sensors wird eine integrale Messung der Teilentladungen durchgeführt. Durch die Differenzmessung bzw. Bildung eines Differenzsignals können Störsignale unterdrückt werden.

Die Bandbreite des mindestens einen Schmalband-Sensors beträgt vorzugsweise mindestens 100 kHz. Vorzugsweise beträgt die Bandbreite des Schmalband-Sensors höchstens 5 MHz.

Die Messzelle der erfindungsgemäßen Messeinrichtung, welche den Behälter und die erste und zweite Elektrode umfasst, ist vorteilhafterweise horizontal angeordnet, d.h. die beiden Elektroden liegen in einer horizontalen Ebene. Diese durchsetzt günstigerweise beide Elektroden mittig. Dadurch kann in einfacher Weise eine symmetrische Anordnung der beiden Elektroden gegenüber dem Faradayschen Käfig ausgebildet werden.

Vorzugsweise sind alle Hochspannung führenden Teile der Messeinrichtung symmetrisch gegenüber dem Faradayschen Käfig angeordnet.

Weitere Vorteile und Einzelheiten der Erfindung werden im Folgenden anhand der beiliegenden Zeichnung erläutert. In dieser zeigen:
Fig. 1 ein Blockschaltbild einer Messeinrichtung gemäß dem Stand der Technik;
Fig. 2 Diagramme der vom Breitband-Sensor und vom Schmalband-Sensor gemäß dem Stand der Technik erhaltenen Messwerte;
Fig. 3 eine schematische Darstellung eines Ausführungsbeispiels einer erfindungsgemäßen Messeinrichtung, wobei die elektrischen Komponenten teilweise nach Art eines Blockschaltbilds dargestellt sind;
Fig. 4 ein Blockschaltbild eines Breitband-Sensors, der den Spannungsabfall an einer Messimpedanz erfasst;
Fig. 5 eine Darstellung einer Prüfzelle;
Fig. 6 und 7 schematische Darstellungen von modifizierten Breitband-Sensoren.

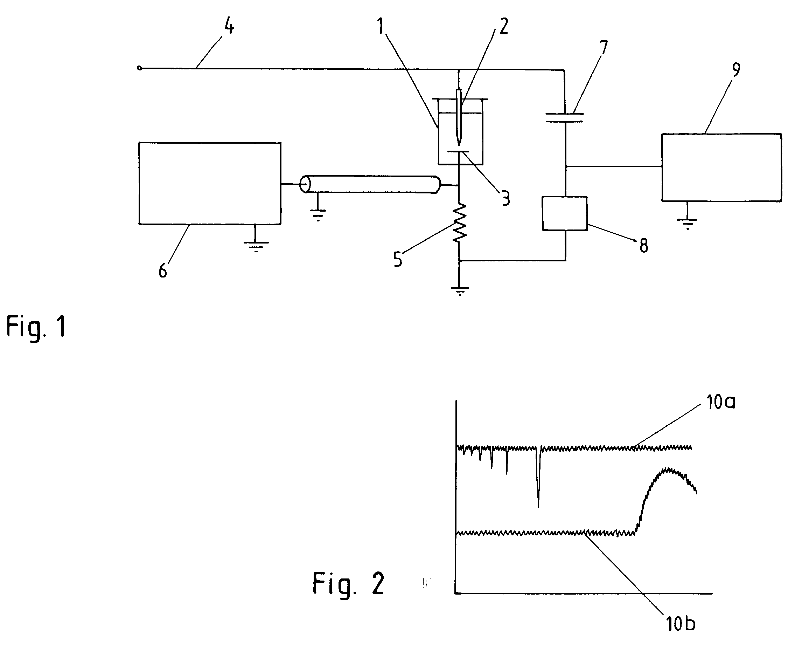

Eine Messeinrichtung zur Messung von Teilentladungen gemäß dem Stand der Technik geht aus Fig. 1 hervor. Die Prüfzelle umfasst einen Behälter 1 zur Aufnahme der zu messenden Isolierflüssigkeit, in welcher zwei Elektroden 2, 3 im Abstand zueinander angeordnet sind. Die Elektrode 2 ist auf ein Hochspannungspotential gelegt. Die angelegte Sinus-Wechselspannung wird im Laufe der Messung erhöht. Die an die Leitung 4 anzuschließende Spannungsquelle ist in Fig. 1 der Einfachheit halber weggelassen. Die andere Elektrode 3 ist über eine Messimpedanz 5 in Form eines ohmschen Widerstandes mit 75 Ω mit dem Erdpotential verbunden. Der Spannungsabfall an der Messimpedanz 5 wird von einem Breitband-Sensor 6 mit einer Bandbreite von 500 MHz erfasst. Der Breitband-Sensor 6 wird von einem Speicher-Oszilloskop gebildet.

Mit der Elektrode 2 ist weiters ein Koppelkondensator 7 mit seiner einen Elektrode verbunden. Die andere Elektrode des Koppelkondensators 7 ist über eine Koppelimpedanz 8 mit Erde verbunden. Die nur nach Art eines Blockschaltbilds dargestellte Koppelimpedanz 8 wird von einem Vierpol gebildet und die an der Koppelimpedanz 8 anliegende Spannung wird von einem Schmalband-Sensor 9 mit einer Bandbreite von 300 kHz erfasst, der von einem Speicher-Oszilloskop gebildet wird.

Zur Messung von Teilentladungen wird die an der Elektrode 2 anliegende Spannung fortlaufend erhöht, bis Teilentladungspulse auftreten. Fig. 2 zeigt als Diagramm 10a das vom Breitband-Sensor 6 abgegebene Signal. In der Ordinate ist die Zeit in Sekunden dargestellt (die anliegende Hochspannung wird während dieser Zeit konstant gehalten) und als Abszisse ist die Spannung dargestellt. Den auftretenden Spannungsspitzen können Ladungswerte für die aufgetretenen Teilentladungen zugeordnet werden.

Diagramm 10b zeigt die vom Schmalband-Sensor 9 abgegebenen Messwerte, die ein integriertes Signal der Teilentladungen darstellen, von welchem die Gesamtladung der aufgetretenen Teilentladungen abgeleitet werden kann.

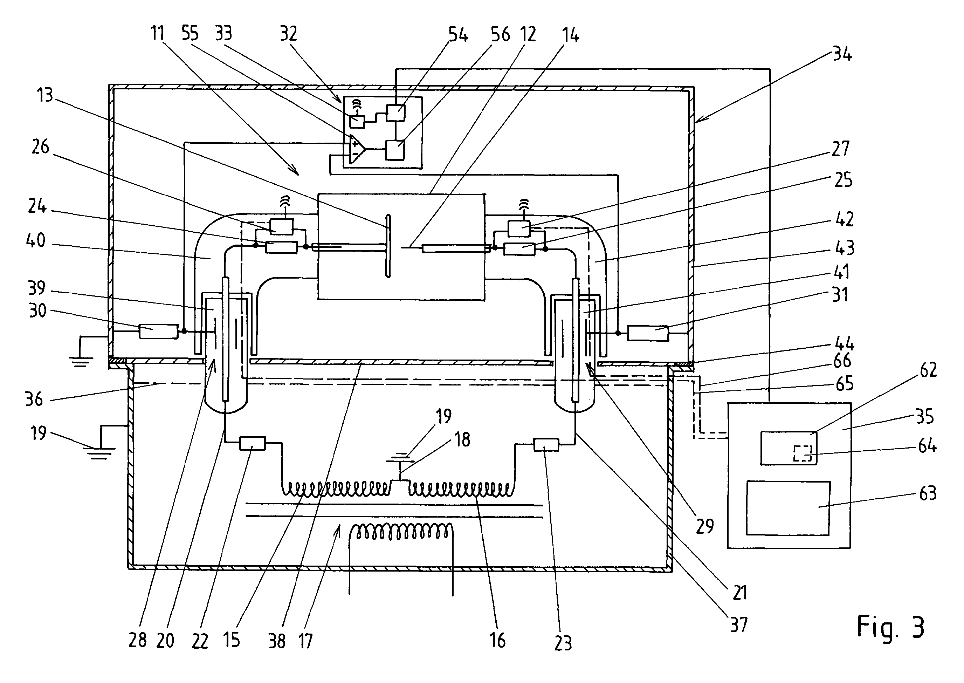

In Fig. 3 ist ein Ausführungsbeispiel für eine erfindungsgemäße Messeinrichtung schematisch dargestellt. Zur Messung von Teilentladungen in einer Isolierflüssigkeit ist eine Prüfzelle 11 vorhanden. Diese umfasst einen Behälter 12, der die zu messende Isolierflüssigkeit aufnimmt. Weiters umfasst die Prüfzelle 11 im Inneren des Behälters 12 und somit in der zu messenden Isolierflüssigkeit angeordnete erste und zweite Elektroden 13, 14, zwischen welche eine Hochspannung angelegt wird. Im gezeigten Ausführungsbeispiel ist die erste Elektrode 13 plattenförmig ausgebildet, beispielsweise mit einem Rogowski-Profil, und die zweite Elektrode 14 weist eine zur ersten Elektrode 13 gerichtete Spitze auf. Die erste Elektrode 13 könnte beispielsweise auch kugelförmig ausgebildet sein.

Zur Spannungsversorgung der ersten und zweiten Elektrode 13, 14 dienen erste und zweite Spannungsquellen 15, 16, die von ersten und zweiten Sekundärwicklungen eines Transformators 17 gebildet werden, zwischen denen ein Mittelabgriff 18 liegt, der auf Erdpotential 19 gelegt ist.

Die an die beiden Elektroden 13, 14 angelegten Spannungen weisen gleiche Amplituden auf (Abweichungen von +/- 5% sind möglich). Die Phasen dieser beiden Sinus-Spannungen sind um 180° zueinander phasenverschoben.

Die an die beiden Elektroden 13, 14 angelegten Spannungen weisen gleiche Amplituden auf (Abweichungen von +/- 5% sind möglich). Die Phasen dieser beiden Sinus-Spannungen sind um 180° zueinander phasenverschoben.

Die erste und zweite Spannungsquelle 15, 16 sind über erste und zweite elektrische Leitungen 20, 21 mit der ersten und zweiten Elektrode 13, 14 verbunden, wobei in diesen elektrischen Leitungen 20, 21 jeweils ein ohmscher Schutzwiderstand 22, 23 und eine Messimpedanz 24, 25 angeordnet sind, die zueinander in Serie geschaltet sind. Die Messimpedanzen 24, 25 werden vorzugsweise ebenfalls von ohmschen Widerständen gebildet. Es werden induktivitätsarme Widerstände eingesetzt, beispielsweise mäanderförmige Metallfilm-Widerstände.

Beispielsweise weisen die Messimpedanzen einen Widerstandswert im Bereich von 25-100 Ω auf. Die Widerstandswerte der Schutzwiderstände 22, 23 sind demgegenüber wesentlich höher, liegen beispielsweise im Bereich von 1 kΩ bis 500 kΩ.

Die Messimpedanzen 24, 25 könnten auch von Vierpolen, beispielsweise ohmschen Widerständen mit parallel geschalteten Kapazitäten gebildet werden.

Der Spannungsabfall an einer jeweiligen Messimpedanz 24, 25 wird von einem jeweiligen Breitband-Sensor 26, 27 erfasst, der parallel zu dieser geschaltet ist. Der Aufbau der ersten und zweiten Breitband-Sensoren 26, 27 wird weiter unten erläutert. Die Messimpedanzen 24, 25 und Breitband-Sensoren 26, 27 liegen innerhalb von Isolatoren 40, 42.

Zwischen der jeweiligen Messimpedanz 24, 25 und dem jeweiligen Schutzwiderstand 22, 23 ist ein jeweiliger Koppelkondensator 28, 29 an die jeweilige elektrische Leitung 20, 21 angekoppelt. Im gezeigten Ausführungsbeispiel ist hierzu jeweils eine Elektrode vorgesehen, die einen Abschnitt der Leitung 20, 21 umgibt und innerhalb eines Isolators 39, 41 angeordnet ist. Der von dieser Elektrode umgebene Abschnitt der Leitung 20, 21 bildet die andere Elektrode des jeweiligen Koppelkondensators 28, 29. Die die elektrische Leitung 20, 21 umgebende Elektrode ist über eine Kop-Die an den Koppelimpedanzen 30, 31, die in Fig. 3 nur nach Art eines Blockschaltbilds eingezeichnet sind, anliegenden Spannungen werden einem gemeinsamen Schmalband-Sensor 32 zugeführt, dessen Aufbau weiter unten genauer erläutert wird.

Der Transformator 17 ist in einem Flüssigkeitsbad mit einer isolierenden Flüssigkeit angeordnet, deren Flüssigkeitsspiegel 36 in Fig. 3 durch eine strichlierte Linie angedeutet ist. Hierzu ist ein Unterteil 37 des Gehäuses der Messeinrichtung als Wanne ausgeführt.

Die vom Unterteil 37 gebildete Wanne ist vorteilhafterweise von einer Abdeckung 38 abgedeckt, die vorzugsweise aus einem isolierenden Material ausgebildet ist.

Oberhalb des Flüssigkeitsspiegels 36 der isolierenden Flüssigkeit verlaufen die Hochspannung führenden elektrischen Leitungen 20, 21 innerhalb von Isolatoren 39-42. Die Isolatoren 39 und 40 und die Isolatoren 41 und 42 sind vorteilhafterweise voneinander abhebbar. Hierbei endet das durch den Isolator 39 bzw. 41 führende Leitungsstück im Bereich von seiner Oberseite und das durch den Isolator 40 bzw. 42 führende Leitungsstück endet im Bereich von dessen Unterseite und im aufeinander aufgesetzten Zustand der Isolatoren 39 und 40 bzw. 41 und 42 liegen diese Leitungsstücke aneinander an. Durch die Isolatoren 40, 42 sind die elektrischen Leitungen 20, 21 bis in das Innere des Behälters 42 der Prüfzelle 11 geführt.

Die Hochspannung führenden Teile sind somit innerhalb einer isolierenden Flüssigkeit (der Flüssigkeit im Unterteil 37 bzw. der zu messenden Isolierflüssigkeit) oder innerhalb eines Isolators 39-42 angeordnet. Es sind somit keine über den freien Luftraum führende Isolierstrecken vorhanden, wodurch die Abmessungen der Messeinrichtung sehr kompakt gehalten werden können. Eine solche Ausbildung ist bei Messeinrichtungen zur Messung der Durchschlagspannung von Isolierflüssigkeiten bekannt.

Die Prüfzelle 11 ist zumindest während der Messung innerhalb eines Oberteils 43 der Messeinrichtung angeordnet. Dieses liegt während der Messung auf einer HF-Dichtung 44 auf, welche zwischen dem Unterteil 37 und dem Oberteil 43 angeordnet ist. Die HF-Dichtung 44 kann beispielsweise von der Abdeckung 38 gehalten sein. Die HF-Dichtung besteht aus einem elektrisch leitfähigen Material, beispielsweise aus einem verzinnten Kupfergeflecht. Das Unterteil 37 und das Oberteil 43 bestehen aus einem elektrisch leitfähigen Material, insbesondere aus Metall und bilden somit zusammen mit der HF-Dichtung 44 einen Faradayschen Käfig, innerhalb von dem zumindest die Hochspannung führenden Teile der Messeinrichtung angeordnet sind.

Anstelle der Ausbildung aus einem elektrisch leitfähigen Material könnten das Unterteil 37 und das Oberteil 43 auch mit einem solchen beschichtet oder armiert sein, insbesondere mit Metall oder einem Metallgeflecht. Die HF-Dichtung 44 könnte auch entfallen und das Oberteil 43 könnte direkt auf dem Unterteil 37 aufliegen.

Vorzugsweise ist das Oberteil 43 aufklappbar oder abhebbar ausgebildet, um einen einfachen Zugang zur Prüfzelle 11 zu ermöglichen. Die Prüfzelle 11 kann günstigerweise durch die beschriebene Trennung in den Isolatoren 39-42 und elektrischen Leitungen abhebbar ausgebildet sein.

Im gezeigten Ausführungsbeispiel erfolgt eine Funk-Datenübertragung der von den Breitband-Sensoren 26, 27 ausgegebenen Messwerte an eine Empfangseinheit 33, beispielsweise über den Bluetooth-Standard. Die Empfangseinheit 33 muss somit innerhalb des Faradayschen Käfigs 34 liegen. Im gezeigten Ausführungsbeispiel ist die Empfangseinheit 33 in den Schmalband-Sensor 32 integriert. Die von der Empfangseinheit 33 empfangenen Daten sowie die vom Schmalband-Sensor ausgegebenen Messwerte werden an eine mit dem Schmalband-Sensor 32 verbundene Auswerteinheit 35 übermittelt, vorzugsweise über eine elektrische Leitungsverbindung, die aus dem Faradayschen Käfig 34 herausführt. Die Empfangseinheit 33 könnte auch separat vom Schmalband-Sensor 32 im Faradayschen Käfig 34 angeordnet sein und über eine eigene elektrische Leitung mit der Auswerteinheit 35 verbunden sein. Weiters könnte eine Datenübertragung vom jeweiligen Breitband-Sensor 26, 27 auch über ein jeweiliges Glasfaserkabel erfolgen. Dieses könnte dann direkt zur Auswerteinheit 35 verlaufen. In Fig. 3 sind solche lichtoptische Leitungen (LOL) bzw. Glasfaserkabel 65, 66 zur Veranschaulichung mit strichlierten Linien angedeutet. Der Breitband-Sensor könnte zur Datenübertragung somit Lasertransmitter aufweisen.

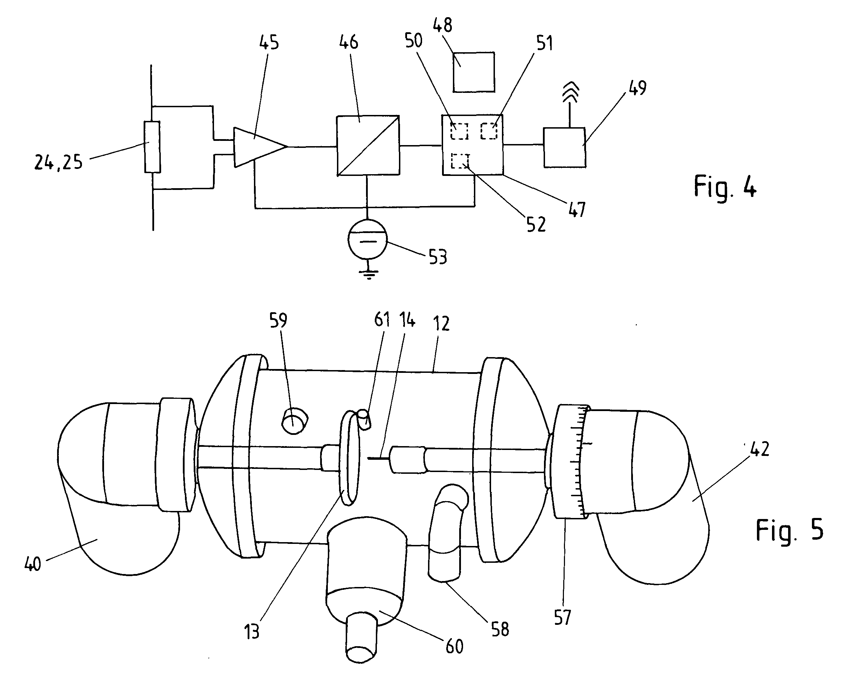

Ein Blockschaltbild für eine mögliche Ausführungsform eines jeweiligen Breitband-Sensors 26, 27 ist in Fig. 4 schematisch dargestellt. Der Spannungsabfall an einer jeweiligen Messimpedanz 24, 25 wird einem jeweiligen Verstärker 45 zugeführt, der parallel zur jeweiligen Messimpedanz 24, 25 geschaltet ist. Ein jeweiliger Verstärker 45 weist vorzugsweise einen in diesen integrierten Impedanzwandler auf. Ein separater Impedanzwandler könnte vorgesehen sein. Das verstärkte Signal des Spannungsabfalls wird einem Analog-Digital-Wandler 46 zugeführt. Das von diesem gewandelte digitale Signal wird einer Mikroprozessoreinheit 47 zugeführt, welche einen Mikroprozessor umfasst. An die Mikroprozessoreinheit ist ein Speicher 48 angeschlossen und/oder in die Mikroprozessoreinheit 47 ist ein Speicher implementiert. Das von der Mikroprozessoreinheit 47 verarbeitete Messsignal wird von einer Übertragungseinheit 49 an die Empfangseinheit 33 übertragen, im gezeigten Ausführungsbeispiel drahtlos, beispielsweise über den Bluetooth-Standard.

Zur Bereitstellung einer ausreichenden Bandbreite weist der Verstärker 45 eine ausreichende Analog-Bandbreite, vorzugsweise im Bereich vom 100 MHz bis 1000 MHz, auf und die Abtastrate des Analog-Digital-Wandlers 46 ist ausreichend hoch, vorzugsweise beträgt diese mindestens 1 GHz, besonders bevorzugt mehr als 2 GHz, beispielsweise 4 GHz oder mehr.

Die Mikroprozessoreinheit 47 ist so programmiert, dass von ihr die eingehenden Pulse gezählt werden. Von der Mikroprozessoreinheit 47 wird somit eine Zähleinheit 50 ausgebildet, die schematisch in strichlierten Linien angedeutet ist. Eine separate Zähleinheit könnte vorgesehen sein.

Weiters werden von der Mikroprozessoreinheit 47 die Amplituden der Pulse ausgewertet, wobei die Amplitudenhöhe mit einer Ladung (pC) korreliert werden kann. Weiters werden günstigerweise die Phasenlagen der erfassten Pulse ausgewertet. Hierzu ist ein Timer vorhanden bzw. die Mikroprozessoreinheit 47 ist so programmiert, dass sie einen solchen Timer 51 ausbildet (ein separater Timer 51 könnte vorgesehen sein).

Weiters kann die Mikroprozessoreinheit 47 so programmiert werden, dass sie eine Korrelationsrecheneinheit 52 ausbildet (eine separate Korrelationsrecheneinheit könnte vorgesehen sein), von der Pulse in der negativen und in der positiven Halbwelle der an die jeweilige Elektrode 13, 14 angelegten Spannung korreliert werden können. Dadurch können Informationen über die Muster der Teilentladungen bzw. die zugrundeliegenden Defekte in der Isolierung erhalten werden. Über den Speicher 48 erfolgt eine Zwischenspeicherung.

Die Stromversorgung erfolgt über eine Batterie oder einen Akkumulator 53, der beispielsweise von Speicherkondensatoren CAPS oder einem Li-Ionenakku gebildet werden kann.

Die Datenübermittlung der Breitband-Sensoren 26, 27 erfolgt im Ausführungsbeispiel wie bereits erwähnt an eine im Schmalband-Sensor 32 angeordnete Empfangseinheit 33. Von dieser werden die Daten über eine Zwischeneinheit 54 des Schmalband-Sensors 32 an die Auswerteinheit 35 übertragen.

Die Auswerteinheit 35 umfasst eine Mikroprozessoreinheit 62 und eine Ausgabevorrichtung, insbesondere eine Anzeige 63 und einen Drucker. Die Mikroprozessoreinheit 62 ist vorteilhafterweise so programmiert, dass eine Korrelationsrecheneinheit 64 ausgebildet wird, von der die von den beiden Breitband-Sensoren 26, 27 abgegebenen Messwerte korreliert werden. Es kann hierzu ein Differenzsignal zwischen den von den beiden Breitband-Sensoren 26, 27 abgegebenen Messwerten gebildet werden. Dadurch können zusätzliche Informationen über die Teilentladungen erhalten werden und/oder Störsignale unterdrückt werden. Eine separate Korrelationsrecheneinheit 62 könnte vorgesehen sein.

Die an den beiden Koppelimpedanzen 30, 31 anliegenden Signale werden einem Subtrahierglied bzw. Differenzverstärker 55 des Schmalband-Sensors 32 zugeführt. Über eine Bearbeitungseinheit 56 und die Zwischeneinheit 54 wird das Signal des Schmalband-Sensors 32 ebenfalls der Auswerteinheit 35 zugeführt. Die Bearbeitungseinheit 56 und die Zwischeneinheit 54 können Teil einer Mikroprozessoreinheit des Schmalband-Sensors 32 sein, d.h. die Mikroprozessoreinheit ist programmiert, um die Signale entsprechend zu bearbeiten und an die Auswerteinheit 35 zu übertragen.

Auf Grund der den von den Breitband-Sensoren 26, 27 empfangenen Signalen kann die Auswerteinheit 35 u.a. die Anzahl der Teilentladungspulse und durch eine Summation der den Teilentladungspulsen jeweils zugeordneten Ladungswerten einen ersten Wert für die den Teilentladungen zukommende gesamte Ladung ausgeben. Auf Grund der vom Schmalband-Sensor 32 empfangenen Messwerten kann die Auswerteinheit 35 einen zweiten Wert für die den Teilentladungen zukommende gesamte Ladung ausgeben.

Ein Messvorgang zur Messung von Teilentladungen in einer Isolierflüssigkeit kann folgendermaßen durchgeführt werden:
Durch eine steigende, an die Primärwicklung des Transformators 17 angelegte Spannung können die an den Elektroden 13, 14 angelegten Spannungen erhöht werden, beispielsweise mit einem Anstieg von 1 kV/s. Die Spannung wird auf eine jeweilige Spannungsstufe erhöht, auf der die Spannung über einen vorgegebenen Zeitraum, z.B. für 10 min, aufrecht erhalten wird. Beispielsweise kann der Anstieg von einer Spannungsstufe zur nächsten 2,5 kV pro Elektrode betragen (sodass die zwischen den Elektroden vorliegende Potentialdifferenz jeweils um 5 kV erhöht wird).

Bei einer jeweiligen Spannungsstufe werden Teilentladungen gemessen. Falls über einen vorgegebenen Beobachtungszeitraum, z.B. von 10 min, ein oder mehrere Teilentladungspulse beobachtet werden, so wird die zwischen den Elektroden 13, 14 vorliegende Potentialdifferenz als PDIV (Partial Discharge Inception Vol-tage) angesehen.

Die Spannung wird weiter stufenweise erhöht, bis bei einer Spannungsstufe ein vorgegebener gesamter Ladungswert der Teilentladung überschritten wird, beispielsweise ein Ladungswert von mehr als 100 pC festgestellt wird. Die Anzahl der bei dieser Teilentladungsstufe festgestellten Spannungspulse und der Spannungswert dieser Spannungsstufe werden festgehalten. Es werden auf diese Weise charakteristische Werte für die Teilentladungen ermittelt.

Der beschriebene Messvorgang könnte auch gegenüber derart modifiziert werden, dass die Spannungserhöhung kontinuierlich, z. B. mit 0,5 kV/s bis 5 kV/s erhöht wird, bis Teilentladungen detektiert werden. Nach dem Einsatz der ersten Teilentladungen wird die Spannung noch etwas weiter erhöht, z. B. um 10%, und danach werden die Teilentladungen für einen vorgegebenen Zeitraum, z. B. 2 min erfasst. Hierbei können charakteristische Größen der Teilentladungen erfasst werden, insbesondere ihre Anzahl, Größen und Phasenlagen.

Fig. 5 zeigt eine Schrägsicht einer möglichen Ausführungsform für eine Prüfzelle 11. Der die Elektroden 13, 14 aufnehmende Behälter 12 besteht aus einem isolierenden, hier transparenten Material. Mittels eines Nonius 57 kann der Abstand zwischen der ersten und der zweiten Elektrode 13, 14 auf einen gewünschten Wert eingestellt werden. Die Isolierflüssigkeit wird über einen Einlauf 58 eingebracht und durch einen Auslauf 59 abgeführt. Über einen Temperaturfühler 60 kann die Temperatur der Isolierflüssigkeit erfasst werden. Weiters ist ein Gasauslass 61 vorhanden. Über diesen kann bei den Teilentladungen gebildetes Gas entnommen und analysiert werden.

Eine erfindungsgemäße Messeinheit zur Messung von Teilentladungen kann vorteilhafterweise so ausgeführt sein, dass zusätzlich auch die Durchbruchsspannung einer Isolierflüssigkeit gemessen werden kann. Hierzu können die Koppelkondensatoren 28, 29 in herkömmlicher Weise herangezogen werden.

Der über den Mittelabgriff 18 fließende Strom kann gemessen werden, um im Falle eines Durchschlags die Spannungen abzuschalten.

Ebenso kann über die Koppelkondensatoren 28, 29 die an den Elektroden 13, 14 anliegende Spannung überwacht werden, um beim Unterschreiten eines vorgegebenen Spannungspegels, z.B. 100 V, den Durchbruch festzustellen und die Abschaltung der Spannung durchzuführen. Damit können Abschaltzeiten im Mikrosekundenbereich erzielt werden, um die Gasbildung und Elektrodenerosion so gering wie möglich zu halten.

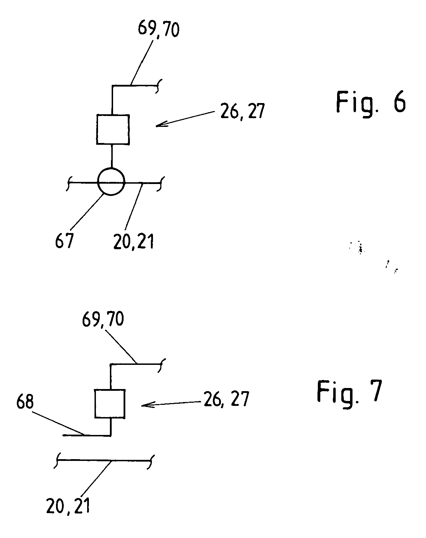

In einer modifizierten Ausführungsform der Erfindung könnten die Messimpedanzen 24, 25 entfallen und die von den Teilentladungen hervorgerufenen Stromimpulse könnten in anderer Weise erfasst werden, um Messwerte für die Teilentladungen zu erhalten. So zeigt Fig. 6 schematisch einen Breitband-Sensor 26 bzw. 27, der von Teilentladungen in der Leitung 20 bzw. 21 hervorgerufene Stromimpulse mittels einer Rogowsky-Spule 67 erfasst. Das Teil 67 könnte in einer weiteren Modifikation auch einen Magnetkern mit einem Hall-Sensor symbolisieren.

Fig. 7 zeigt schematisch eine weitere Möglichkeit für die Ausbildung eines berührungslos die Stromimpulse in den Leitungen 20, 21 erfassenden Breitband-Sensors 26, 27 und dieser weist eine Antenne 68 zum Empfang des von der Leitung 20, 21 abgestrahlten elektromagnetischen Feldes auf.

Solche berührungslos arbeitende Breitband-Sensoren 26, 27 sind hierbei vorzugsweise wiederum zwischen der ersten bzw. zweiten Elektrode 13, 14 und dem ersten bzw. zweiten Koppelkondensator 28, 29 angeordnet, beispielsweise etwa in den Bereichen, in denen die Messimpedanzen 24, 25 in Fig. 3 eingezeichnet sind.

Die Breitband-Sensoren 26, 27 könnten die Messwerte für die Teilentladungen somit berührungslos erfassen, wobei sie vorzugsweise gegenüber den Hochspannung führenden Leitungen 20, 21 elektrisch isoliert sein können. Die Breitband-Sensoren 26, 27 müssten in diesem Falle nicht auf Hochspannung liegen und die Datenübertragung der Messwerte könnten ausgehend von den Breitband-Sensoren 26, 27 über elektrische Leitungen 69, 70 erfolgen. Diese könnten beispielsweise direkt zur Auswerteinheit 35 verlaufen. Eine Übertragung über den freien Raum oder über ein Glasfaserkabel ist natürlich wiederum ebenso möglich.

### Legende zu den Hinweisziffern:

- 1: Behälter
- 2: Elektrode
- 3: Elektrode
- 4: Leitung
- 5: Messimpedanz
- 6: Breitband-Sensor
- 7: Koppelkondensator
- 8: Koppelimpedanz
- 9: Schmalband-Sensor
- 10: Diagramm
- 11: Prüfzelle
- 12: Behälter
- 13: erste Elektrode
- 14: zweite Elektrode
- 15: erste Spannungsquelle
- 16: zweite Spannungsquelle
- 17: Transformator
- 18: Mittelabgriff
- 19: Erdpotential
- 20: erste elektrische Leitung
- 21: zweite elektrische Leitung
- 22: erster Schutzwiderstand
- 23: zweiter Schutzwiderstand
- 24: erste Messimpedanz
- 25: zweite Messimpedanz
- 26: erster Breitband-Sensor
- 27: zweiter Breitband-Sensor
- 28: erster Koppelkondensator
- 29: zweiter Koppelkondensator
- 30: erste Koppelimpedanz
- 31: zweite Koppelimpedanz
- 32: Schmalband-Sensor
- 33: Empfangseinheit
- 34: Faradayscher Käfig
- 35: Auswerteinheit
- 36: Flüssigkeitsspiegel
- 37: Unterteil
- 38: Abdeckung
- 39: Isolator
- 40: Isolator
- 41: Isolator
- 42: Isolator
- 43: Oberteil
- 44: HF-Dichtung
- 45: Verstärker
- 46: Analog-Digital-Wandler
- 47: Mikroprozessoreinheit
- 48: Speicher
- 49: Übertragungseinheit
- 50: Zähleinheit
- 51: Timer
- 52: Korrelationsrecheneinheit
- 53: Akkumulator
- 54: Zwischeneinheit
- 55: Differenzverstärker
- 56: Bearbeitungseinheit
- 57: Nonius
- 58: Einlauf
- 59: Auslauf
- 60: Temperaturfühler
- 61: Gasauslass
- 62: Mikroprozessoreinheit
- 63: Anzeige
- 64: Korrelationsrecheneinheit
- 65: Glasfaserkabel
- 66: Glasfaserkabel
- 67: Rogowsky-Spule
- 68: Antenne
- 69: elektrische Leitung
- 70: elektrische Leitung

## Patentansprüche

1. Messeinrichtung zur Messung von Teilentladungen in Isolierflüssigkeiten, welche erste und zweite Elektroden (13, 14), die in einem Behälter zur Aufnahme der zu messenden Isolierflüssigkeit angeordnet sind und zwischen denen eine Spannung anlegbar ist, mindestens einen Breitband-Sensor (26, 27), von dem Messwerte für die Teilentladungen ausgebbar sind, und einen Faradayschen Käfig (34) umfasst, innerhalb von dem der Behälter (12) mit den Elektroden (13, 14) angeordnet ist, **dadurch gekennzeichnet, dass** die Messeinrichtung erste und zweite Spannungsquellen (15, 16) umfasst, mit denen an den beiden Elektroden (13, 14) jeweils eine Wechselspannung gegenüber einem Erdpotential (19) anlegbar ist, wobei die an den beiden Elektroden (13, 14) anliegenden Wechselspannungen zumindest im Wesentlichen gleiche Amplituden aufweisen und um 180° gegeneinander phasenverschoben sind.

2. Messeinrichtung nach Anspruch 1, **dadurch gekennzeichnet, dass** der mindestens eine Breitband-Sensor (26, 27) zur Erfassung von von Teilentladungen hervorgerufenen Stromimpulsen den Spannungsabfall an einer Messimpedanz erfasst oder dass der mindestens eine Breitband-Sensor (26, 27) zur Erfassung von von Teilentladungen hervorgerufenen Stromimpulsen eine Rogowsky-Spule oder einen Hall-Sensor aufweist oder dass der mindestens eine Breitband-Sensor (26, 27) zur Erfassung von von Teilentladungen hervorgerufenen Stromimpulsen eine Antenne aufweist, welche ein von solchen Stromimpulsen hervorgerufenes elektromagnetisches Feld empfängt.

3. Messeinrichtung nach Anspruch 1 oder 2, **dadurch gekennzeichnet, dass** ein erster Breitband-Sensor (26) von Teilentladungen hervorgerufene Stromimpulse in einer ersten elektrischen Leitung (20), die zwischen der ersten Spannungsquelle (15) und der ersten Elektrode (13) verläuft, oder ein von solchen Stromimpulsen hervorgerufenes elektromagnetisches Feld oder einen Spannungsabfall an einer ersten, in die erste Leitung (20) geschalteten Messimpedanz (24) erfasst und dass ein zweiter Breitband-Sensor (27) von Teilentladungen hervorgerufene Stromimpulse in einer zweiten elektrischen Leitung (21), die zwischen der zweiten Spannungsquelle (16) und der zweiten Elektrode (14) verläuft, oder ein von solchen Stromimpulsen hervorgerufenes elektromagnetisches Feld oder einen Spannungsabfall an einer zweiten, in die zweite Leitung (21) geschalteten Messimpedanz (25) erfasst.

4. Messeinrichtung nach einem der Ansprüche 1 bis 3, **dadurch gekennzeichnet, dass** ein jeweiliger Breitband-Sensor (26, 27) die von ihm erfassten Messwerte mittels einer jeweiligen Übertragungseinheit (49) über den freien Raum oder über ein Glasfaserkabel (65, 66) an eine Empfangseinheit (33) überträgt.

5. Messeinrichtung nach einem der Ansprüche 1 bis 4, **dadurch gekennzeichnet, dass** ein jeweiliger Breitband-Sensor (26, 27) von einer jeweiligen Batterie oder einem jeweiligen Akkumulator (53) mit Strom versorgt ist.

6. Messeinrichtung nach einem der Ansprüche 1 bis 5, **dadurch gekennzeichnet, dass** die erste und zweite Spannungsquelle (15, 16) von ersten und zweiten Sekundärwicklungen eines Transformators (17) gebildet werden, wobei ein zwischen der ersten und zweiten Sekundärwicklung liegender Mittelabgriff (18) auf Erdpotential (19) liegt.

7. Messeinrichtung nach einem der Ansprüche 1 bis 5, **dadurch gekennzeichnet, dass** ein jeweiliger Breitband-Sensor (26, 27) einen A/D-Wandler umfasst.

8. Messeinrichtung nach einem der Ansprüche 1 bis 7, **dadurch gekennzeichnet, dass** ein jeweiliger Breitband-Sensor (26, 27) eine Zähleinheit (50) zum Zählen der von Teilentladungen hervorgerufenen Pulse umfasst.

9. Messeinrichtung nach einem der Ansprüche 1 bis 8, **dadurch gekennzeichnet, dass** ein jeweiliger Breitband-Sensor (26, 27) einen Timer (51) zur Erfassung von Phasenlagen von von den Teilentladungen hervorgerufenen Pulsen umfasst.

10. Messeinrichtung nach einem der Ansprüche 1 bis 9, **dadurch gekennzeichnet, dass** ein jeweiliger Breitband-Sensor (26, 27) eine Korrelationsrecheneinheit (52) zur Korrelation von von Teilentladungen hervorgerufenen Pulsen aufweist, die während der positiven der an die jeweilige Elektrode (13, 14) angelegten Spannung auftreten, mit von Teilentladungen hervorgerufenen Pulsen, die während der negativen Halbwelle der an die jeweilige Elektrode (13, 14) angelegten Spannung auftreten.

11. Messeinrichtung nach einem der Ansprüche 3 bis 10, **dadurch gekennzeichnet, dass** eine Auswerteinheit (35) eine Korrelationsrecheneinheit (62) zur Korrelation von vom ersten Breitband-Sensor (26) ausgegebenen Messwerten mit vom zweiten Breitband-Sensor (27) ausgegebenen Messwerten umfasst.

12. Messeinrichtung nach einem der Ansprüche 1 bis 11, **dadurch gekennzeichnet, dass** an eine die erste Elektrode (13) mit der ersten Spannungsquelle (15) verbindende erste elektrische Leitung (20) ein erster Koppelkondensator (28) angekoppelt ist, der über eine erste Koppelimpedanz (30) mit dem Erdpotential (19) verbunden ist, wobei die an der ersten Koppelimpedanz (30) anliegende Spannung einem Schmalband-Sensor (32) zugeführt ist.

13. Messeinrichtung nach Anspruch 12, **dadurch gekennzeichnet, dass** an eine die zweite Elektrode (14) mit der zweiten Spannungsquelle (16) verbindende zweite elektrische Leitung (21) ein zweiter Koppelkondensator (29) angekoppelt ist, der über eine zweite Koppelimpedanz (31) mit dem Erdpotential (19) verbunden ist, wobei der Schmalband-Sensor (32) einen Differenzverstärker (55) zur Erfassung der Differenz zwischen der an der ersten Koppelimpedanz (30) und an der zweiten Koppelimpedanz (31) anliegenden Spannungen aufweist.

14. Messeinrichtung nach einem der Ansprüche 1 bis 13, **dadurch gekennzeichnet, dass** die Hochspannung führenden Teile der Messeinrichtung symmetrisch gegenüber dem Faradayschen Käfig (34) angeordnet sind.

15. Verfahren zur Messung von Teilentladungen in Isolierflüssigkeiten, wobei zwischen einer ersten und einer zweiten Elektrode (13, 14), die in der zu messenden Isolierflüssigkeit angeordnet sind, eine Spannung angelegt wird und die von der angelegten Spannung hervorgerufenen Teilentladungen mit mindestens einem Breitband-Sensor (26, 27) gemessen werden, **dadurch gekennzeichnet, dass** an die erste und an die zweite Elektrode (13, 14) jeweils eine Wechselspannung gegenüber dem Erdpotential (19) angelegt wird, wobei die beiden Wechselspannungen zumindest im Wesentlichen gleiche Amplituden aufweisen und um 180° zueinander phasenverschoben sind.

## Claims

1. Measurement device for measuring partial discharges in dielectric liquides which comprises first and second electrodes (13, 14) which are arranged in a container for receiving the dielectric liquid for measurement and between which a voltage can be applied, at least one wide-band sensor (26, 27) from which measured values for the partial discharges can be emitted, and a Faraday cage (34) within which the container (12) having the electrodes (13, 14) is arranged, **characterised in that** the measurement device comprises first and second voltage sources (15, 16) by which respective alternating voltages relative to an earth potential (19) can be applied to the two electrodes (13, 14), the alternating voltages applied to the two electrodes (13, 14) being of at least substantially the same amplitudes and being 180° out of phase with one another.

2. Measurement device according to claim 1, **characterised in that** the at least one wide-band sensor (26, 27) for sensing current pulses caused by partial discharges senses the voltage drop at a measuring impendance or **in that** the at least one wide-band sensor (26, 27) for sensing current pulses caused by partial discharges has a Rogowski coil or a Hall-effect sensor, or **in that** the at least one wide-band sensor (26, 27) for sensing current pulses caused by partial discharges has an antenna which receives an electromagnetic field caused by such current pulses.

3. Measurement device according to claim 1 or 2, **characterised in that** a first wide-band sensor (26) senses current pulses caused by partial discharges on a first electrical line (20) which extends between the first voltage source (15) and the first electrode (13), or an electromagnetic field caused by such current pulses or a voltage drop at a first measuring impedance (24) connected into the first line (20), and **in that** a second wide-band sensor (27) senses current pulses caused by partial discharges on a second electrical line (21) which extends between the second voltage source (16) and the second electrode (14), or an electromagnetic field caused by such current pulses or a voltage drop at a second measuring impedance (25) connected into the second line (21).

4. Measurement device according to one of claims 1 to 3, **characterised in that**, by means of a respective transmitting unit (49), either given wide-band sensor (26, 27) transmits the measured values sensed by it to a receiving unit (33) across free space or via a fibre optic cable (65, 66).

5. Measurement device according to one of claims 1 to 4, **characterised in that** either given wide-band sensor (26, 27) is supplied with power by a respective non-storage battery or a respective storage battery (53).

6. Measurement device according to one of claims 1 to 5, **characterised in that** the first and second voltage sources (15, 16) are formed by first and second secondary windings of a transformer (17), a centre tapping (18) situated between the first and second secondary windings being at earth potential (19).

7. Measurement device according to one of claims 1 to 5, **characterised in that** either given wide-band sensor (26, 27) comprises an A/D converter.

8. Measurement device according to one of claims 1 to 7, **characterised in that** either given wide-band sensor (26, 27) comprises a counting unit (50) for counting the pulses caused by partial discharges.

9. Measurement device according to one of claims 1 to 8, **characterised in that** either given wide-band sensor (26, 27) comprises a timer (51) for sensing phase angles of pulses caused by the partial discharges.

10. Measurement device according to one of claims 1 to 9, **characterised in that** either given wide-band sensor (26, 27) has a correlation-calculating unit (52) for correlating pulses caused by partial discharges which occur during the positive half-cycle of the voltage applied to the respective electrode (13, 14) with pulses caused by partial discharges which occur during the negative half-cycle of the voltage applied to the respective electrode (13, 14)

11. Measurement device according to one of claims 3 to 10, **characterised in that** an analysing unit (35) comprises a correlation-calculating unit (62) for correlating measured values emitted by the first wide-band sensor (26) with measured values emitted by the second wide-band sensor (27).

12. Measurement device according to one of claims 1 to 11, **characterised in that** there is coupled to the first electrical line (20) connecting the first electrode (13) to the first voltage source (15) a first coupling capacitor (28) which is connected to the earth potential (19) via a first coupling impedance (30), the voltage applied to the first coupling impedance (30) being fed to a narrow-band sensor (32).

13. Measurement device according to claim 12, **characterised in that** there is coupled to a second electrical line (21) connecting the second electrode (14) to the second voltage source (16) a second coupling capacitor (29) which is connected to the earth potential (19) via a second coupling impedance (31), the narrow-band sensor (32) having a difference amplifier (55) for sensing the difference between the voltages applied to the first coupling impedance (30) and to the second coupling impedance (31).

14. Measurement device according to one of claims 1 to 13, **characterised in that** the parts of the measurement device which carry high voltage are symmetrically arranged relative to the Faraday cage (34).

15. Method of measuring partial discharges in dielectric liquids, a voltage being applied between a first and a second electrode (13, 14) which are arranged in the dielectric liquid for measurement, and the partial discharges caused by the applied voltage being measured by at least one wide-band sensor (26, 27), **characterised in that** respective alternating voltages relative to the earth potential (19) are applied to the first and second electrodes (13, 14), the two alternating voltages being of at least substantially the same amplitudes and being 180° out of phase with one another.

## Revendications

1. Dispositif de mesure de décharges partielles dans des liquides isolants qui comporte une première et une seconde électrodes (13, 14) qui sont montées dans un récipient de réception du liquide isolant à mesurer et entre lesquelles, peut être établie une tension, au moins un capteur à large bande (26, 27) permettant de délivrer des valeurs de mesure des décharges partielles et une cage de Faraday (34), à l'intérieur de laquelle est monté le récipient (12) équipé des électrodes (13, 14),
**caractérisé en ce que**
le dispositif de mesure comporte une première et une seconde sources de tension (15, 16) permettant respectivement d'appliquer sur les deux électrodes (13, 14) une tension alternative par rapport au potentiel de terre (19), les tensions alternatives établie sur les deux électrodes (13, 14) ayant au moins essentiellement la même amplitude et étant décalées en phase de 180° par rapport à l'autre.

2. Dispositif de mesure conforme à la revendication 1,
**caractérisé en ce que**
pour détecter les impulsions de courant provoquées par des décharges partielles, le capteur à large bande (26, 27) détecte, la chute de tension sur une impédance de mesure, ou comporte, une bobine de Rogowsky ou un capteur à effet Hall, ou comporte une antenne qui reçoit un champ électromagnétique engendré par de telles impulsions de courant.

3. Dispositif de mesure conforme à la revendication 1 ou 2,
**caractérisé en ce que**
un premier capteur à large bande (26) détecte des impulsions de courant provoquées par des décharges partielles dans une première conduite électrique (20) qui s'étend entre la première source de tension (15) et la première électrode (13), ou un champ électromagnétique engendré par de telles impulsions de courant, ou une chute de tension sur une impédance de mesure (24), branchée sur la première conduite (20) et un second capteur à large bande (27) détecte des impulsions de courant provoquées par des décharges partielles dans une seconde conduite électrique (21) qui s'étend entre la seconde source de tension (16) et la seconde électrode (14), ou un champ électromagnétique engendré par de telles impulsions de courant ou une chute de tension sur une seconde impédance de mesure (25) branchée sur la seconde conduite (21).

4. Dispositif de mesure conforme à l'une des revendications 1 à 3,
**caractérisé en ce que**
chaque capteur à large bande (26, 27) transmet les valeurs de mesure qu'il a détectées, a une unité de réception (33), au moyen d'une unité de transmission respective (49), par l'espace libre ou par un câble en fibre de verre (65, 66).

5. Dispositif de mesure conforme à l'une des revendications 1 à 4,
**caractérisé en ce que**
chaque capteur à large bande (26, 27) est alimenté en courant par une batterie respective ou un accumulateur respectif (53).

6. Dispositif de mesure conforme à l'une des revendications 1 à 5,
**caractérisé en ce que**
la première source de tension (15) et la seconde source de tension (16) sont formées par un premier et un second enroulement secondaires d'un transformateur (17), une prise médiane (18) située entre le premier et le second enroulement secondaire étant au potentiel de terre (19).

7. Dispositif de mesure conforme à l'une des revendications 1 à 5,
**caractérisé en ce que**
chaque capteur à large bande (26, 27) comprend un convertisseur A/D.

8. Dispositif de mesure conforme à l'une des revendications 1 à 7,
**caractérisé en ce que**
chaque capteur à large bande (26, 27) comporte une unité de comptage (50) pour permettre de compter les impulsions provoquées par des décharges partielles.

9. Dispositif de mesure conforme à l'une des revendications 1 à 8,
**caractérisé en ce que**
chaque capteur à large bande (26, 27) comprend une horloge (51) pour permettre de détecter les positions de phase des impulsions provoquées par les décharges partielles.

10. Dispositif de mesure conforme à l'une des revendications 1 à 9,
**caractérisé en ce que**
chaque capteur à large bande (26, 27) comporte une unité de calcul de corrélation (52) pour permettre d'effectuer la corrélation d'impulsions provoquées par des décharges partielles qui se présentent pendant la demi-onde positive de la tension appliquée sur l'électrode respective (13, 14) et d'impulsions provoquées par des décharges partielles qui se présentent pendant la demi-onde négative de la tension appliquée sur l'électrode respective (13, 14).

11. Dispositif de mesure conforme à l'une des revendications 3 à 10,
**caractérisé en ce qu'**
une unité d'exploitation (35) comporte une unité de calcul de corrélation (62) pour effectuer la corrélation de valeurs de mesure délivrées par le premier capteur à large bande (26) et de valeurs de mesure délivrées par le second capteur à large bande (27).

12. Dispositif de mesure conforme à l'une des revendications 1 à 11,
**caractérisé en ce que**
sur une première conduite électrique (20) reliant la première électrode (13) avec la première source de tension (15) est branché un premier condensateur de couplage (28) qui est relié au potentiel de terre (19), par l'intermédiaire d'une première impédance de couplage (30) la tension appliquée sur la première impédance de couplage (30) étant transmise à un capteur à bande étroite (32).

13. Dispositif de mesure conforme à la revendication 12,
**caractérisé en ce que**
sur une seconde conduite électrique (21) reliant la seconde électrode (14) avec la seconde source de tension (16) est branché un second condensateur de couplage (29), qui est relié au potentiel de masse (19) par l'intermédiaire d'une seconde impédance de couplage (31), le capteur a bande étroite (32) comprenant un amplificateur différenciateur (55) pour permettre de détecter la différence entre la tension appliquée sur la première impédance de couplage (30) et la tension appliquée sur la seconde impédance de couplage (31).

14. Dispositif de mesure conforme à l'une des revendications 1 à 13,
**caractérisé en ce que**
les parties du dispositif de mesure conduisant la haute tension sont disposées symétriquement par rapport à la cage de Faraday (34).

15. Procédé de mesure de décharges partielles dans des liquides isolants, selon lequel une tension est appliquée entre une première électrode et une seconde électrode (13, 14) qui sont situées dans le liquide isolant à mesurer, et les décharges partielles provoquées par la tension appliquée, sont mesurées par au moins un capteur à large bande (26, 27),
**caractérisé en ce que**
sur la première et sur la seconde électrode (13, 14) est respectivement appliquée une tension alternative par rapport au potentiel de terre (19), et les deux tensions alternatives ont au moins essentiellement la même amplitude et sont décalées en phase de 180° l'une par rapport à l'autre.
